# EUROPEAN PATENT APPLICATION

(11) **EP 1 420 302 A1**
(43) Date of publication of application: **19.05.2004**
(21) Application number: 03257194.5
(22) Date of filing: 14.11.2003
(51) Int. Cl.: G03F 7/20

(54) **Lithographic apparatus and device manufacturing method**

(30) Priority: 18.11.2002 EP 02257938
(71) Applicant: ASML Netherlands B.V., 5503 LA Veldhoven (NL)
(72) Inventor: Bleeker, Arno Jan, 5563 CE Westerhoven (NL)
(74) Representative: Leeming, John Gerard

(57) **Abstract**

In an immersion lithography apparatus a transparent plate (12) is provided between the substrate table (WT) and the projection lens (PL) to prevent currents in the liquid (10) exerting forces on the projection lens that might tend to distort the reference frame (RF). The plate is maintained still relative to the reference frame by an actuator system (13) responsive to a position sensor (14) mounted on the reference frame. The transparent plate may have the same refractive index as the liquid.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for filling the space between the final element of said projection system and said substrate with a liquid.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

It has been proposed to immerse the substrate in a lithographic projection apparatus in a liquid having a relatively high refractive index, e.g. water, so as to fill the space between the final element of the projection lens and the substrate. The point of this is to enable imaging of smaller features since the exposure radiation will have a shorter wavelength in the liquid. (The effect of the liquid may also be regarded as increasing the effective NA of the system.)

However, when the substrate table is moved, e.g. in a scanning exposure, in the liquid, the viscosity of the liquid means that a force will be exerted on the projection lens and hence to the reference frame to which all position sensors in the apparatus are attached. To allow accurate positioning of the substrate and mask stages, the reference frame must provide an extremely rigid and stable reference for the different sensors mounted on it.
The force exerted on it via the liquid will distort the reference frame sufficiently to invalidate the different position measurements based upon it.

It is an object of the present invention to provide a lithographic projection apparatus in which the space between the substrate and projection system is filled with a liquid yet the reference frame is effectively isolated from disturbances caused by movement of the substrate stage.

This and other objects are achieved according to the invention in a lithographic apparatus as specified in the opening paragraph, characterized by:
- a transparent plate provided between said projection system and said substrate table and mechanically isolated from said projection system;
- means for maintaining said transparent plate substantially stationary relative to said projection system.

The transparent plate between the projection system and the substrate table isolates the projection system from the substrate table and prevents the transmission of forces through the liquid to the projection lens and hence to the reference frame. Movements of the substrate table therefore do not disturb the reference frame and the sensors mounted on it.

Preferably, the transparent plate has a refractive index at the wavelength of the projection beam substantially the same as the refractive index of the liquid at that wavelength. In this way, the transparent plate does not introduce any unwanted optical effects.

The transparent plate is preferably so shaped and positioned that the liquid is divided into two parts, one part between the projection lens and the plate and the other part between the plate and the substrate table, and there is no liquid communication between the two parts. With this arrangement, complete isolation between the substrate table and projection lens can be assured.

The means for maintaining the transparent plate stationary preferably comprises an actuator system which may comprise a position sensor for measuring the position of the transparent plate relative to the projection system and actuator means coupled to said position sensor for maintaining said transparent plate at a predetermined position relative to said projection system. The position sensor is preferably mounted on the reference frame and the actuator means is preferably mounted on a base frame from which the reference frame is mechanically isolated. The actuator means may also be responsive to positioning instructions provided to the positioning means for the substrate table to provide a feedforward control in addition to or instead of feedback control via the position sensor.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and
- providing a liquid to fill the space between the substrate and a final element of a projection system used in said step of projecting;
characterized by
- providing a transparent plate mechanically isolated from said projection system between said substrate and said final element of said projection system and maintaining said transparent plate substantially stationary relative to said projection system.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm).

Embodiments of the invention will now be described, by way of example only, with reference to the accompanying schematic drawings in which:
Figure 1 depicts a lithographic projection apparatus according to an embodiment of the invention;
Figure 2 depicts the substrate table immersion and projection lens isolation arrangements of the embodiment of the invention.

In the Figures, corresponding reference symbols indicate corresponding parts.

### Embodiment 1

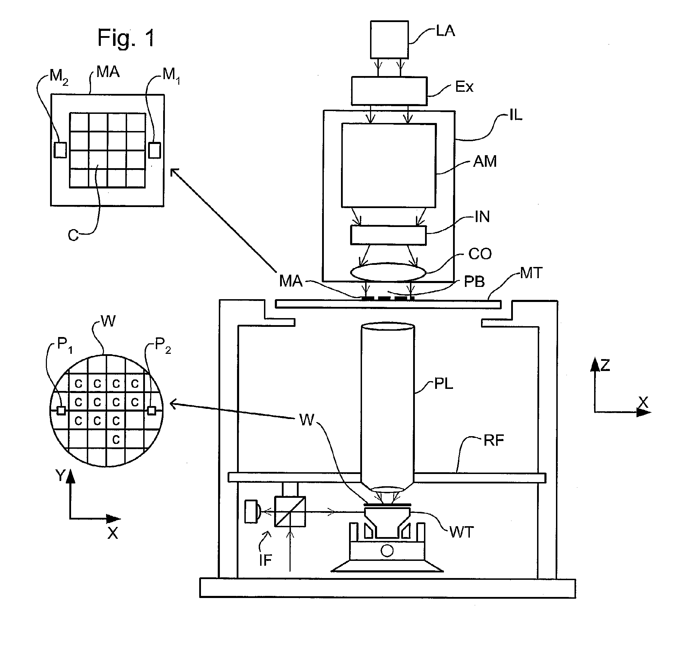

Figure 1 schematically depicts a lithographic projection apparatus according to a particular embodiment of the invention. The apparatus comprises:
a radiation system Ex, IL, for supplying a projection beam PB of radiation (*e.g.* DUV radiation), which in this particular case also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e*.*g*. a refractive lens system) for imaging an irradiated portion of the mask MA onto a target portion C (*e.g.* comprising one or more dies) of the substrate W.
As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
- In step mode, the mask table MT is kept essentially stationary, and an entire mask image is projected in one go *(i. e.* a single "flash") onto a target portion C. The substrate table WT is then shifted in the x and/or y directions so that a different target portion C can be irradiated by the beam PB;
- In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V = Mv*, in which *M* is the magnification of the lens PL (typically, *M* = 1/4 or 1/5). In this manner, a relatively large target portion C can be exposed, without having to compromise on resolution.

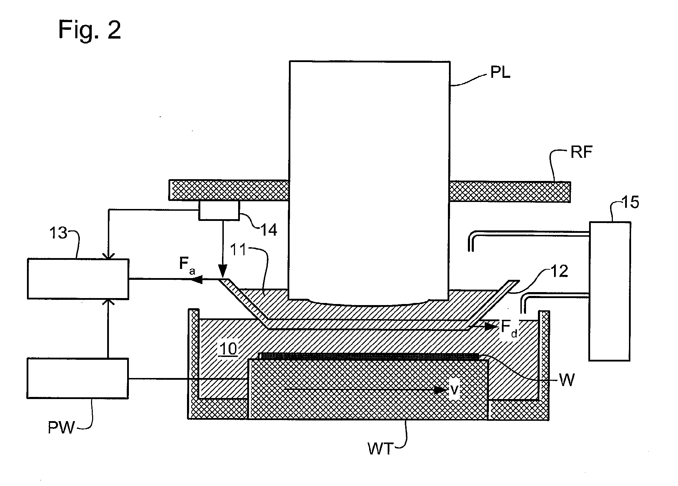

Figure 2 shows the substrate stage in greater detail. The substrate table WT is immersed in a liquid 10 having a relatively high refractive index, e.g. water, provided by liquid supply system 15. The liquid has the effect that the radiation of the projection beam has a shorter wavelength in the liquid than in air or a vacuum, allowing smaller features to be resolved. It is well known that the resolution limit of a projection system is determined, *inter alia*, by the wavelength of the projection beam and the numerical aperture of the system. The presence of the liquid may also be regarded as increasing the effective numerical aperture.

A transparent plate, or dish, 12 is positioned between the projection system PL and the substrate table WT and also filled with liquid 11, preferably the same liquid as liquid 10. Thus, the entire space between the projection system PL and the substrate W is filled with liquid but the liquid 11 between the plate 12 and the projection system PL is separate from the liquid 10 between the plate 12 and the substrate W.

The transparent plate 12 preferably has the same refractive index as the liquid 10, 11 at least at the wavelength of the projection beam and any sensor beams, e.g. of through-the lens alignment systems, that may pass through the plate. This avoids optical side-effects, which otherwise would need to be characterized and compensated for. Of course the whole plate need not be transparent, only those parts through which beams must pass.

The substrate table WT is moved, e.g. in the direction indicated by arrow v, by second positioning means PW, e.g. to perform a scanning exposure. The movement of the substrate table causes currents in the liquid 10 which in turn will exert forces on the plate 12. To prevent the forces being further propagated to the projection system PL and reference frame RF, the transparent plate 12 is maintained stationary relative to the projection lens PL by an actuator system. Since the plate 12 is stationary there is no disturbance of the liquid 11 and hence no force transference to the projection system PL.

The actuator system for maintaining the plate 12 stationary comprises actuators 13 which are controlled in a feedback loop in response to the position of the plate 12 as measured by position sensor 14 mounted on the reference frame RF and/or in a feedforward loop based on positioning instructions sent to the second positioning means PW. The control system for the actuator system can implement anti noise measures. Interferometers, capacitive sensors, and encoders may be used as the position sensors and Lorentz motors or voice coil motors as the actuators.

The use of actuators rather than a stiff connection to the bath in which the substrate table WT is immersed is preferable as if facilitates easy removal of the substrates from the substrate table WT after imaging without unduly increasing the volume of liquid in the bath.

It will be appreciated that the force F_{d} exerted on the plate 12 is not necessarily parallel to or linearly related to the motion v of the substrate table WT, because of turbulence and delays in the transmission of force through the fluid 10. This may limit the usefulness of feedforward control. Nevertheless, it is important that the force Fₐ exerted on the plate 12 counters the force F_{d} transmitted through the liquid 10 sufficiently that disturbances in the liquid 11 are kept low enough that the forces transferred to the projection lens are within acceptable limits.

It should be noted that in some circumstances, e.g. if the substrate table movements are relatively slow and the viscosity of the liquid low, it may not be necessary to use an actuator system to maintain the plate 12 stationary, instead it may be fixed, e.g. to the base frame or another stationary part of the apparatus isolated from the reference frame.

Whilst specific embodiments of the invention have been described above, it will be appreciated that the invention may be practiced otherwise than as described. The description is not intended to limit the invention.

## Claims

1. A lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for filling the space between the final element of said projection system and said substrate with a liquid; **characterized by**:
- a transparent plate provided between said projection system and said substrate table and mechanically isolated from said projection system;
- means for maintaining said transparent plate substantially stationary relative to said projection system.

2. Apparatus according to claim 1 wherein said transparent plate has a refractive index at the wavelength of the projection beam substantially the same as the refractive index of the liquid at that wavelength.

3. Apparatus according to claim 1 or 2 wherein said transparent plate is so shaped and positioned that the liquid is divided into two parts, one part between the projection lens and the plate and the other part between the plate and the substrate table, and there is no liquid communication between the two parts.

4. Apparatus according to claim 1, 2 or 3 wherein said means for maintaining said transparent plate substantially stationary comprises an actuator system.

5. Apparatus according to claim 4 wherein said actuator system comprises a position sensor for measuring the position of the transparent plate relative to the projection system and actuator means coupled to said position sensor.

6. Apparatus according to claim 5 wherein said position sensor is mounted on a reference frame which also supports said projection system.

7. Apparatus according to claim 6 wherein said actuator means is mounted on a base frame from which the reference frame is mechanically isolated.

8. Apparatus according to any one of claims 4 to 7, wherein said actuator system is controlled in a feedback manner.

9. Apparatus according to any one of claims 4 to 7, wherein said actuator system is controlled in a feedforward manner.

10. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and
- providing a liquid to fill the space between the substrate and a final element of a projection system used in said step of projecting;
**characterized by**
- providing a transparent plate mechanically isolated from said projection system between said substrate and said final element of said projection system and maintaining said transparent plate substantially stationary relative to said projection system.
